# EUROPEAN PATENT SPECIFICATION

(11) **EP 0 806 374 B1**
(45) Date of publication and mention of the grant of the patent: **16.08.2000**
(21) Application number: 97302646.1
(22) Date of filing: 17.04.1997
(51) Int. Cl.: B65D 85/38, B65D 25/04, B65D 25/10, H01L 21/00

(54) **Container for storing and transporting fragile objects**
Behälter zum Lagern und Transportieren von zerbrechlichen Gegenständen
Récipient pour le stockage et le transport d'objets fragiles

(30) Priority: 30.04.1996 US 641378; 30.04.1996 US 641381
(43) Date of publication of application: 12.11.1997
(73) Proprietor: International Business Machines Corporation, Armonk, N.Y. 10504 (US)
(72) Inventor: Advocate, William H., Staatsburg, NY 12580 (US); Ausschnitt, Christopher P., Brookfield, Connecticut 06804 (US); Hugg, Joshua S., Wappingers Falls, NY 12590 (US)
(74) Representative: Williams, Julian David

(56) References cited:
- WO-A-92/21146
- FR-A- 2 502 921
- US-A- 3 486 631
- US-A- 4 620 740
- US-A- 4 981 222
- PATENT ABSTRACTS OF JAPAN vol. 008, no. 049 (E-230), 6 March 1984 & JP 58 202542 A (NIPPON DENKI KK), 25 November 1983,
- RESEARCH DISCLOSURE, no. 336, 1 April 1992, page 254 XP000304795 "PRODUCT CARRIER"
- PATENT ABSTRACTS OF JAPAN vol. 009, no. 159 (E-326), 4 July 1985 & JP 60 037723 A (NIPPON DENKI KK), 27 February 1985,

## Description

The present invention relates to a container for storing and transporting fragile objects such as semiconductor wafers, lithography reticles, and the like.

A reticle is used as a mask between a light source used for exposure and a photosensitive polymer on a wafer in semiconductor lithography. By masking off areas from exposure a pattern can be generated on the wafer by causing the photosensitive polymer to react. Depending on the type of resist used, the exposed portion will either dissolve or be resistant to subsequent developing, where the image is finally resolved.

If there happens to be contamination on the reticle, the pattern resulting from the contaminants will deviate from what is desired. To prevent this, a transparent membrane or pellicle is attached to and positioned over the reticle. Contaminants will gather on the pellicle instead of the reticle, and will be out of focus during exposure and not resolved, thus not affecting the desired pattern. The pellicle membrane is very thin and very fragile, so that great care is needed in protecting it from tears.

Currently, reticles are stored and transported in cassettes. For a Micrascan (Micrascan is a Registered Trade Mark of SVG Lithography, Inc, Wilton, Connecticut) tool, for example, a single reticle is stored in a vertical position inside a box-like cassette and the reticle tends to rattle around inside, often causing damage to the pellicle.

Thus, there remains a need for a reticle storage and transport container which reduces or prevents damage to reticles resulting from them moving around in the container.

US Patent 4,620,740 discloses a cabinet for the storage and carrying of a plurality of phonograph record albums in non-warping disposition comprised of a box-like structure having top, bottom, rear and side panels and having a pivoted, fold-away carrying handle and open front extremity. The combined effect of the position of the handle and its pivoted nature causes the open front extremity of the cabinet to be angled upwardly when the cabinet is carried by the handle.

In accordance with the present invention, there is now provided a container for storing and transporting fragile objects, comprising: a plurality of walls including a pair of side walls, forming a box with an open side; a plurality of spaced apart partitions between the side walls for separating the objects; and a handle attached to the container; characterised by: a plurality of support pegs attached externally to a wall of the container, the support pegs differing in length in order to maintain the objects in an angled orientation during storage, and the handle being attached off-centre to the container in order to maintain the objects in an angled orientation during transport.

This arrangement advantageously enables reticles to be stored and transported without damage from them moving around in the container.

It will be appreciated that the present invention may be employed for carrying other types of fragile objects.

Preferred embodiments of the present invention will now be described by way of example only with reference to the accompanying drawings, in which:
FIGURE 1 shows a container with angled partitions; and
FIGURE 2 shows a container with non-angled partitions and support pegs to maintain the container in an angled position; all in accordance with the present invention.

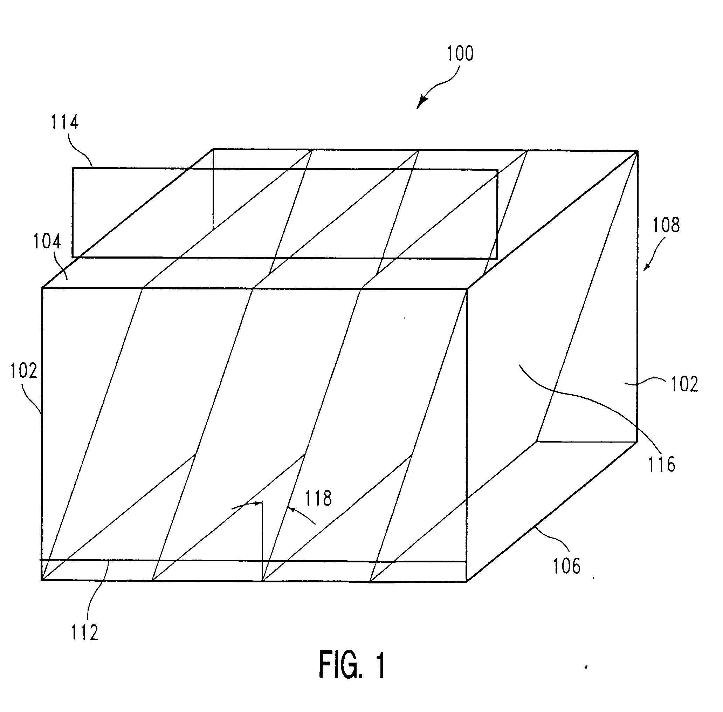

Referring now to the drawings and more particularly to Figure 1, a container with angled partitions is shown. This type of container is well-suited to the storage and transport of reticles, although other types of fragile objects may be stored and transported as well. Container 100 has side walls 102, top side 104, bottom side 106, and back side 108 generally forming a box with an open side 110 opposing back side 108. A retaining bar 112 or other suitable retaining means is attached to side walls 102 and spans open side 110 so that the reticles do not slide out of open side 110 during transport. Retaining bar 112 may be positioned at any suitable distance from bottom wall 106 so that the reticles are easily inserted into container 100 yet prevented from sliding out.

Container 100 has a handle 114 for carrying, which may be positioned off-center on top side 104 so that during transport container 100 tilts, with back wall 108 lower than open side 110. This further prevents the reticles from sliding out.

Inside container 100 are partitions or dividers 116 between side walls 102 which separate the reticles. Partitions 116 are fixed at an off-vertical angle 118. The degree of angle 118 depends on the center of gravity of the reticles, as well as the coefficient of friction of the reticle with respect to the partition material, but must be large enough (e.g. when approaching vertical) or small enough (e.g. when approaching horizontal) so that the reticles rest against partitions 116 and minimize or prevent moving or rattling during loading or transport.

Generally, the angle 118 should be such that the following conditions are satisfied:

x_{g} < x₀

x'_{g} > x₀

where
- x_{g} =: calculated or measured x component of the center of gravity for the object, assuming the direction of tilt is perpendicular to the x-y plane;
- x'_{g} =: relative x position of x_{g} upon tilting the object;
- x₀ =: measured width of object, assuming the direction of tilt is perpendicular to the y-z plane, also the pivot point around which the object is tilted.

A working model was built with an angle 118 of 18 degrees (72 degrees from horizontal), which satisfies the above conditions. The number and size of partitions 116 are dependent upon the reticle size and weight, as well as the desired weight and dimension of container 100 when loaded.

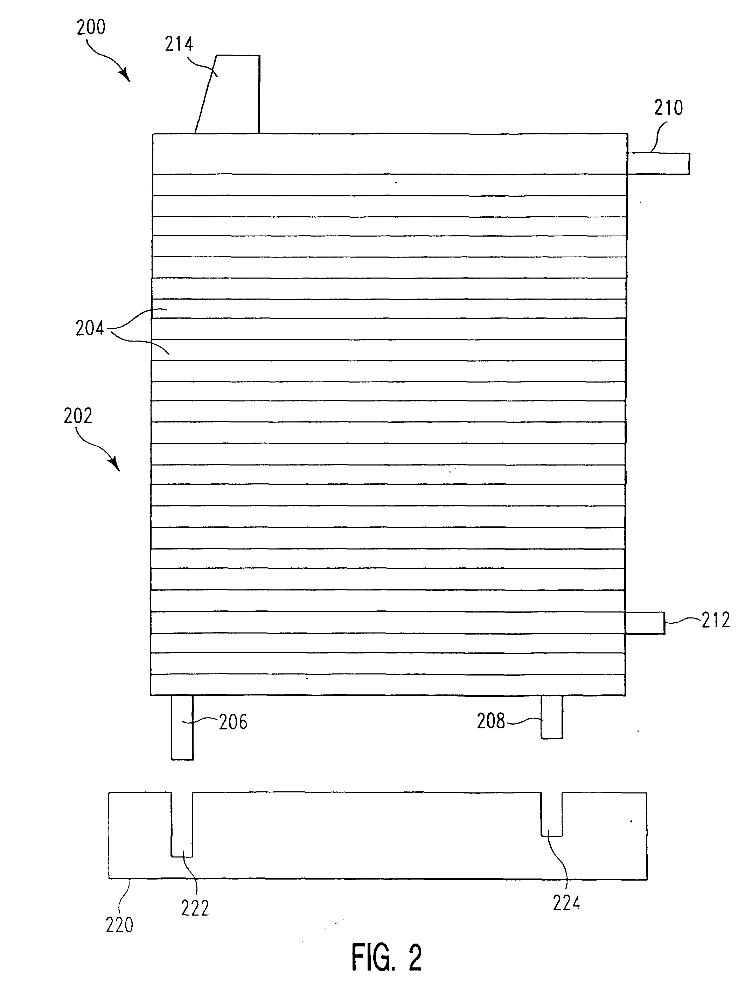

An alternate method for maintaining objects in an angled orientation during storage and transport is illustrated in Figure 2. Container 200 is similar to container 100 shown in Figure 1, but is better suited to the storage and transport of fragile semiconductor wafers, and has the added advantage of being able to be used with automated wafer handling apparatus for loading into processing tools.

Container 200 has an open side 202, and non-angled partitions 204 for separating the wafers. Support peg pairs 206, 208 (back ones not visible) of differing lengths are attached externally near the corners on one side of container 200 so that container 200 tilts away from open side 202 during storage, and partitions 204 are effectively angled slightly off-horizontal. The lengths of peg pairs 206, 208 (and thus the effective angle of partitions 204) is dependent upon the same factors as with partitions 116 in container 100, and are generally set so that the desired angle is achieved when container 200 is supported by peg pairs 206, 208. Alternately, support peg pairs 210, 212 of differing lengths can be used when placing container 200 on a surface with open side 202 facing upwards to effectively angle partitions 204 slightly off-vertical.

The angling of the wafers or other objects in container 200 has an additional advantage. It is common to imprint bar codes for production tracking at the edge of the wafers. In a typical wafer cassette in which the wafers are stored in a vertical stack, it is difficult if not impossible to read the bar codes while the wafers are in the cassette. With an angled orientation of the proper degree as described, it is possible to scan the bar codes while in the container and thus improve tracking and selectivity of wafers within the cassette through the production process.

To maintain the wafers in an angled position during transport, an off-center handle 214 is attached similar to handle 112. The wafers are thus prevented from sliding out while being carried.

In order for container 200 to be used with an automated wafer handling apparatus, a tool interface 220 is positioned next to the tool (not shown). Tool interface 220 has slot pairs 222, 224 with depths corresponding to the lengths of support peg pairs 206 and 208, respectively. When support peg pairs 206, 208 are inserted in slots 222, 224, partitions 204 are horizontal and the wafers in container 200 can be automatically loaded and unloaded from the tool.

In summary, a container has been provided for storing and transporting reticles which prevents damage from them moving around in the container, and which is suitable for carrying other types of fragile objects such as semiconductor wafers. The present invention is described herein in the context of a reticle or wafer carrier merely as a specific example, and is not meant to limit applicability of the invention to semiconductor technology. Those skilled in the art will understand that the invention is broadly applicable to any container in which it is desirable to store and transporting fragile objects, comprising a pair of side walls, a top wall, a bottom wall, and a back wall, forming a box with one open side; a plurality of spaced apart partitions between the side walls for separating the objects; and means to maintain the objects in an angled orientation during storage and transport so that the objects rest against the partitions and do not easily move.

While the invention has been described in terms of specific embodiments, it is evident in view of the foregoing description that numerous alternatives, modifications and variations will be apparent to those skilled in the art. Thus, the invention is intended to encompass all such alternatives, modifications and variations which fall within the scope of the invention and the appended claims.

## Claims

1. A container (100) for storing and transporting fragile objects, comprising:
a plurality of walls, including a pair of side walls (102), forming a box with an open side (110);
a plurality of spaced apart partitions (116) between the side walls for separating the objects; and
a handle (114) attached to the container;
characterised by:
a plurality of support pegs (206, 208, 210, 212) attached externally to a wall of the container, the support pegs differing in length in order to maintain the objects in an angled orientation during storage; and
the handle (114) being attached off-centre to the container (100) in order to maintain the objects in an angled orientation during transport.

2. The container of claim 1 wherein the partitions are angled in order to maintain the objects in an angled orientation during storage and transport.

3. The container of claim 2 wherein the angle (118) of the partitions is such that the following conditions are satisfied:
x_{g} < x₀
x'_{g} > x₀
where
x_{g} = calculated or measured x component of the centre of gravity for the object, assuming the direction of tilt is perpendicular to the x-y plane;
x'_{g} = relative x position of x_{g} upon tilting the object;
x₀ = measured width of object, assuming the direction of tilt is perpendicular to the y-z plane, also the pivot point around which the object is tilted.

4. The container of any preceding claim further comprising a retaining means (112) attached to the side walls and spanning the open side for retaining the objects inside the container during transport.

5. The container of any preceding claim wherein the objects are semiconductor wafers, further comprising means to maintain the wafers in a horizontal orientation for automated loading into a processing tool.

6. The container of claim 6 wherein the means to maintain the wafers in a horizontal orientation for automated loading comprises a tool interface (220) having slots (222, 224) of differing depth corresponding to the lengths of the support pegs.

7. The container of any preceding claim wherein the plurality of walls includes a back wall (108) further comprising a handle attached off-centre to the container such that in transport the back wall is lower than the open side.

8. The container of any preceding claim wherein the fragile objects are reticles.

## Patentansprüche

1. Ein Behälter (100) zum Lagern und Transportieren zerbrechlicher Gegenstände, bestehend aus:
Einer Vielzahl von Wänden, einschließlich eines Paars Seitenwände (102), die einen Kasten mit einer offenen Seite (110) bilden;
einer Vielzahl von beabstandeten Zwischenwänden (116) zwischen den Seitenwänden zum Trennen der Objekte; und
einem an dem Behälter befestigten Handgriff (114);
gekennzeichnet durch:
Eine Vielzahl von Tragzapfen (206, 208, 210, 212), die außen an einer Wand des Behälters angeordnet sind, wobei die Tragzapfen unterschiedliche Längen aufweisen, um die Objekte während der Lagerung in winkliger Ausrichtung zu halten; und
der Handgriff (114) außermittig am Behälter (100) angebracht ist, um die Objekte während des Transports in winkliger Ausrichtung zu halten.

2. Der Behälter gemäß Anspruch 1, in dem die Zwischenwände winklig angeordnet sind, um die Objekte beim Lagern und Transport in winkliger Ausrichtung zu halten.

3. Der Behälter gemäß Anspruch 2, in dem der Winkel (118) der Fächer so ist, daß die folgende Bedingung erfüllt ist:
x_{g} < x₀
x'_{g} > x₀
dabei ist
x_{g} = die berechnete oder gemessene x-Komponente des Schwerpunkts für das Objekt, unter der Annahme, daß die Richtung des Kippens senkrecht zur x-y Ebene steht;
x'_{g} = relative x-Position von x_{g} beim Kippen des Objekts;
x₀ = gemessene Breite des Objekts, unter der Annahme, daß die Richtung des Kippens senkrecht zur y-z Ebene steht, auch der Drehpunkt, um den das Objekt gekippt wird.

4. Der Behälter gemäß einem beliebigen der vorstehenden Ansprüche, der ferner umfaßt ein Haltemittel (112), das an den Seitenwänden befestigt ist und die offene Seite überspannt zum Halten der Objekte beim Transport innerhalb des Behälters.

5. Der Behälter gemäß einem beliebigen der vorstehenden Ansprüche, in dem die Objekte Halbleiter-Wafer sind, und der ferner Mittel aufweist zum Halten der Wafer in einer horizontalen Ausrichtung zum automatischen Laden in ein Bearbeitungswerkzeug.

6. Der Behälter gemäß Anspruch 6, in dem die Mittel zum Halten der Wafer in einer horizontalen Ausrichtung zum automatischen Laden umfassen eine Werkzeugschnittstelle (220) mit Schlitzen (222, 224) unterschiedlicher Tiefen entsprechend den Längen der Tragzapfen.

7. Der Behälter gemäß einem beliebigen der vorstehenden Ansprüche, in dem die Vielzahl der Wände eine hintere Wand (108) beinhaltet, und ferner ein außermittig angeordneter Handgriff am Behälter vorgesehen ist, so daß beim Transport die hintere Wand niedriger liegt als die offene Seite.

8. Der Behälter gemäß einem beliebigen der vorstehenden Ansprüche, in dem die zerbrechlichen Objekte Retikel sind.

## Revendications

1. Récipient (100) pour le stockage et le transport d'objets fragiles, comprenant :
une pluralité de parois, y compris une paire de parois latérales (102), formant une boîte avec un côté ouvert (110) ;
une pluralité de cloisons (116) entre les parois latérales, espacées les unes par rapport aux autres pour séparer les objets ; et
une poignée (114) fixée sur le récipient ;
caractérisé par :
une pluralité de chevilles de soutien (206, 208, 210, 212) saillantes sur une paroi du récipient, les chevilles de soutien étant de longueurs différentes afin de maintenir les objets en biais durant le stockage ; et
la poignée (114) étant excentrée par rapport au récipient (100) afin de maintenir les objets en biais pendant le transport.

2. Récipient selon la revendication 1, où les cloisons sont inclinées afin de maintenir les objets en biais pendant le stockage et le transport.

3. Récipient selon la revendication 2, où l'angle d'inclinaison (118) des cloisons est tel que les conditions suivantes sont remplies :
x_{g} < x₀
x'_{g} > x₀
où
x_{g} = abscisse mesurée ou calculée du centre de gravité de l'objet, en assumant que la direction de l'inclinaison est perpendiculaire au plan x-y ;
x'_{g} = position relative x de x_{g} quand on incline l'objet ;
x₀ = largeur mesurée de l'objet, en assumant que la direction de l'inclinaison est perpendiculaire au plan y-z, également le point de pivot pour l'inclinaison de l'objet.

4. Récipient selon l'une quelconque des revendications précédentes, comprenant en outre un moyen de retenue (112) fixé contre les parois latérales et s'étendant le long du côté ouvert pour retenir les objets à l'intérieur du récipient pendant le transport.

5. Récipient selon l'une quelconque des revendications précédentes, où les objets sont des tranches semi-conductrices, comprenant en outre un moyen pour maintenir les tranches à l'horizontale pour un chargement automatique dans un outil de traitement.

6. Récipient selon la revendication 6, où le moyen pour maintenir les tranches à l'horizontale pour un chargement automatique, comprend une interface utilitaire (220) munie de fentes (222, 224) de différentes profondeurs correspondant aux longueurs des chevilles de soutien.

7. Récipient selon l'une quelconque des revendications précédentes, où la pluralité de parois comprend une paroi arrière (108) comprenant en outre une poignée excentrée sur le récipient de manière à ce que, pendant le transport, la paroi arrière soit plus basse que le côté ouvert.

8. Récipient selon l'une quelconque des revendications précédentes, où les objets fragiles sont des réticules.
